Europäisches Patentamt

European Patent Office

Office européen des brevets

(11) Publication number: **0 197 286 B1**

# EUROPEAN PATENT SPECIFICATION

(45) Date of publication of patent specification: **18.09.91**   (51) Int. Cl.5: **G03F 7/36**

(21) Application number: **86102665.6**

(22) Date of filing: **28.02.86**

(54) **A dry development method for a resist film.**

(30) Priority: **29.03.85 JP 68286/85**

(43) Date of publication of application:
**15.10.86 Bulletin 86/42**

(45) Publication of the grant of the patent:
**18.09.91 Bulletin 91/38**

(84) Designated Contracting States:
**DE FR GB**

(56) References cited:
**FR-A- 2 522 532**
**GB-A- 1 181 114**

**IBM TECHNICAL DISCLOSURE BULLETIN, vol. 19, no. 1, June 1976, page 316, New York, US; R. FEDER et al.: "Dry development of photoresists"**

(73) Proprietor: **FUJITSU LIMITED**
**1015, Kamikodanaka Nakahara-ku**
**Kawasaki-shi Kanagawa 211(JP)**

(72) Inventor: **Katoh, Shinya**
**8-2-303, Shimomeguro 2 chome**
**Meguro-ku Tokyo, 153(JP)**

(74) Representative: **Seeger, Wolfgang, Dipl.-Phys.**
**SEEGER & SEEGER Patentanwälte & European Patent Attorneys Georg-Hager-Strasse 40**
**W-8000 München 70(DE)**

PHOTOGRAPHIC SCIENCE AND ENGINEER-ING, vol. 27, no. 4, July/August 1983, pages 146-149, Society of Photographic Scientists and Engineers, Easton, Pennsylvania, US; K. SUGITA et al.: "Dry etching of polymer coatings by deep ultraviolet irradiation"

PATENT ABSTRACTS OF JAPAN, vol. 9, no. 169 (E-328)[1892], 13th July 1985; & JP-A-60 43 824 (FUJITSU K.K.) 08-03-1985

PATENT ABSTRACTS OF JAPAN, vol. 6, no. 151 (E-124)[1029], 11th August 1982; & JP-A-57 75 426 (TOKYO SHIBAURA DENKI K.K.) 12-05-1982

IBM TECHNICAL DISCLOSURE BULLETIN, vol. 26, no. 6, November 1983, page 301, New York, US; W.J. LEIGH et al.: "Acceleration of ablative photoetching of polymers"

PATENT ABSTRACTS OF JAPAN, vol. 7, no. 87 (P-190)[1232], 12th April 1983; & JP-A-58 14 132 (NIPPON DENSHIN DENWA KOSHA) 26-01-1983

## Description

### BACKGROUND OF THE INVENTION

The present invention relates to a method for developing a resist film, more specifically to a dry development method for generating a desired pattern of a resist film on a substrate.

In the manufacturing of a semiconductor circuit, a wet process is generally employed for the development of a resist film formed on a substrate such as a silicon wafer. For instance, chloro-methyl polystyrene (CMS), which is widely used as a high resolution and high contrast negative type resist for electron beam lithography, is developed by an organic solution composed of iso-amyl acetate and ethyl cellosolve or of acetone and iso-propyl alcohol.

However, the wet development process for resist films usually involves the following problems: severe controls required for the temperature and concentration of the developing solution (developer); contamination for the substrate by a residue mainly consisting of the resist removed off and dissolved in the developer or in the rinsing solution.

Negative type resist films generally have another problem relating to the tendency of swelling thereof when soaked in the developing solutions such as the organic solution. The swelling is apt to leave scum at the edge of the remaining resist film and results in the low resolution of the resist pattern compared with the resolution achieved by using positive type resist films.

Above mentioned problems in the wet development also confront the conventional photo-resists, more or less, however, they are more serious for the resist films used in the electron beam lithography which is becoming indispensable to the modern VLSI trend requiring patterns of submicron rule.

The aforesaid problems in the wet development of resist films can be eliminated if a dry method is made practical for the development of resist films. Although several dry processes have been incorporated in the manufacturing of VLSIs semiconductor circuits, however, it seems that there are few disclosures concerning dry development of resist films, including one utilizing an oxygen plasma for developing a negative photo-resist film. (J. N. Smith et al. "A Production Viable Plasma Developable Photoresist" Semiconductor International, December 1979)

However, the above described dry development needs expensive equipment for producing the plasma, including a vacuum chamber and pumping system, a gas-introducing system for oxygen and a radio-frequency power supplying system. Further, these systems require complicated and time consuming steps for controlling the process. Therefore, it is desired to provide a cost-effective dry development method that can be carried out in the atmospheric air without involving any complicated process control. Further, the dry development method must be applicable to an electron beam resist.

"Photographic Science and Engineering, Volume 27 (1983) July/ Aug., No. 4, Easton, Pennsylvania, USA" discloses a dry method of direct etching by UV irradiation. The UV-etching is carried out by changing temperature, ambient gas and pressure.

### SUMMARY OF THE INVENTION

It is, therefore, an object of the present invention to provide a dry development method which can be carried out easily and cost-effectively.

It is another object of the present invention to provide a dry development method applicable to an electron beam resist film.

The above objects can be attained by a dry development process wherein an electron beam sensitive resist film is formed on a substrate such as a silicon wafer, the resist film is subject to a selective irradiation of an electron beam for creating therein a latent image of a desired pattern, and then, to a Deep UV exposure in an oxidizing gas for being selectively removed according to the image. More specifically, if the resist is a negative type, the portions not irradiated by the electron beam are removed during the Deep UV exposure while the portions irradiated by the electron beam are left on the substrate so as to generate the desired pattern of the resist film. The remainder resist film pattern is used as the mask in the subsequent conventional process.

As an exemplary negative type resist film, a chloro-methyl polystyrene (CMS) film has been examined in the dry development according to the present invention. The Deep UV interacts with oxygen in the oxidizing gas such as air and generates ozone and oxygen radicals. When receiving the attack of the ozone and oxygen radicals, the unexposed portion of the resist film is converted into volatile substances including $CO$, $CO_2$ and $H_2O$ and removed from the substrate. The dry development performed in an atmospheric environment allows the substrate to be free from the problems of contamination by the developer and of the severe process control in the wet development. Further, the dry development method eliminates the need for a vacuum chamber, gas-introducing system and radio-frequency power source required in the aforesaid dry developing method using oxygen plasma.

## BRIEF DESCRIPTION OF THE DRAWINGS

FIG.1 is a schematic cross-section of an exemplary apparatus employed for the dry development method of the present invention;

FIG.2 is a graph showing the relation between the decrease in thickness and exposure time in a dry development of a CMS resist film; and

FIGs.3A to 3C are cross-sectional views illustrating an exemplary process of a dry development in accordance with the present invention.

## DESCRIPTION OF PREFERRED EMBODIMENTS

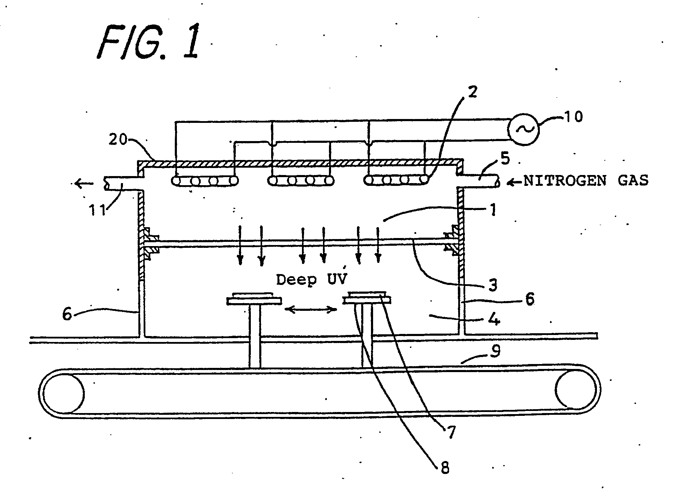

FIG.1 is a schematic cross-section of an exemplary apparatus employed for the dry development method of the present invention.

Referring to FIG.1, a chamber 20 formed from stainless steel and having a height of 500mm, width of 400mm and length of 700mm, for example, is partitioned into a UV generating room 1 and a work room 4 by a quartz plate 3. The UV generating room 1 is provided with UV sources 2 such as low-pressure mercury lamps utilizing a discharge in mercury vapor and xenon, each of which is supplied an input power of about 100watts and is energized by an external power source 10 for providing a Deep UV irradiation intensity of 20mW/cm$^2$. The UV sources 2 afford a Deep UV radiation including wavelength components 1849Å and 2537Å (10Å = 1 nm), which is applied to the work room 4 through the quartz plate 3. In FIG.1, three UV sources 2 are illustrated, for instance.

Quartz has a sufficient transmission characteristic for the Deep UV, thereby allowing efficient use of the UV. The UV generating room 1 is further provided with an inlet port 5 and an outlet port 11 both for supplying the flow of a coolant gas such as nitrogen for the UV sources 2. The chamber 20 is provided with respective gate portions 6 at both sides of the work room 4 in the length thereof, thereby allowing each table 8 for supporting a substrate 7 such as a silicon wafer to come in and out of the room 4 through the gates portions 6 in accordance with the movement of a belt conveyer 9. The chamber 20 also has a role of a shield for preventing operators or instruments placed in the neighborhood from damages by the strong Deep UV irradiation. The work room 4 is opened for the atmospheric air, the process control therefor is easier compared with that in the prior art dry development using a vacuum chamber.

The substrates 7 such as a silicon wafers each having a resist film formed thereon are subjected to the Deep UV irradiation during passing through the work room 4. The resist film on each substrate 7, which has a latent image of a desired pattern generated therein in advance by a selective exposure to an electron beam, is developed by the Deep UV irradiation in the oxidizing gas such as air. The development of the resist film is performed according to the differential reaction rates between the respective portions thereof subjected to and not subjected to the electron beam exposure.

The Deep UV OF 2537Å transmitted through the quartz plate 3 reacts with the oxygen in the atmospheric air, for example, in the work room 4 and produces ozone ($O_3$).

$$hv\ (2537Å) + O_2 = O + O$$
$$O_2 + O = O_3$$

The ozone, $O_3$, having strong oxidizing power causes an oxidation reaction with the resist film as follows.

$$O_3 + C_nH_mO_k = CO + CO_2 + H_2O \qquad (1)$$

where $C_nH_mO_k$ stands for the chemical formula of the resist film. The gaseous products at the right side of the reaction reaction equation (1) diffuse into the atmosphere in the work room 4 and are finally removed from the room 4 through the aforesaid gate portions 6.

On the other hand, $O_3$ absorbs the Deep UV of 1849Å and generates oxygen radicals ($O^*$) having strong chemical activities.

$$hv\ (1848Å) + O_3 = O^* + O_2$$

The oxygen radical, $O^*$, reacts with the resist film as follows.

$$O^* + C_nH_mO_k = CO + CO_2 + H_2O \qquad (2)$$

The gaseous products in the the reaction equation (2) are also removed from the work room 4 through the aforesaid gate portions 6.

In a negative resist such as CMS, the above oxidation reaction occurs relatively faster at the unexposed portion to the electron beam than the exposed portion, thus, the differential removal, i.e. development, of the resist film is achieved.

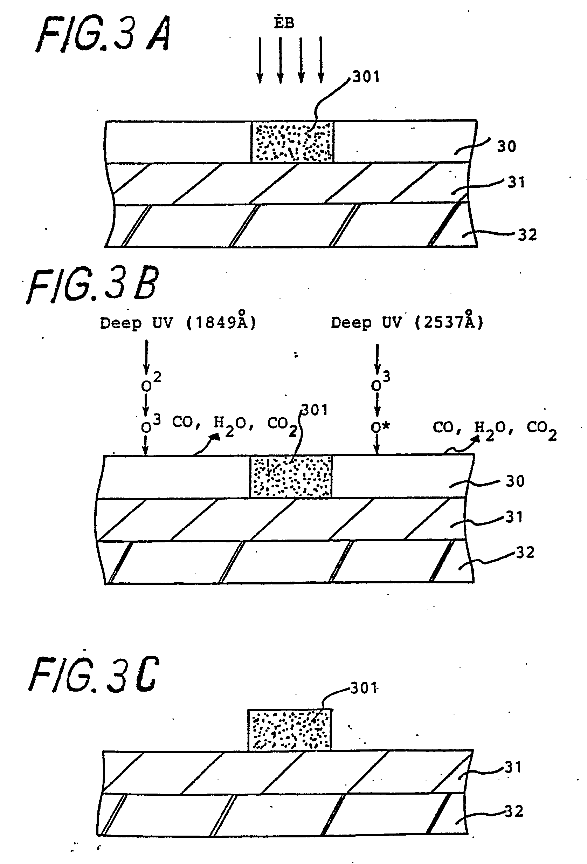

An exemplary process for a dry development of a resist film in accordance with the present invention will be explained with reference to FIGs.3A to 3C cross-sectional views. Referring to FIG.3A, an electron beam sensitive negative type resist film 30 is formed on a thin metal layer 31, a chromium layer, for instance, which is deposited on a substrate 32 such as glass. A portion 301 of the resist film 30 is selectively exposed to an electron beam EB which causes a cross-linking reaction in the negative type resist film 30. Thus, the portion 301 is rendered to be chemically inactive compared with the portions not exposed to the electron beam. In other words, an image of a desired pattern is stored as a chemically inactive region in a negative type resist film.

When irradiated by a Deep UV of 1849Å or 2537Å in an oxidizing gas such as atmospheric air, the resist film 30 reacts with the ozone $O_3$ or oxygen radicals $O^*$ produced in the oxidizing gas and is removed in the forms of gaseous products such as CO, $CO_2$ and $H_2O$, as shown in FIG.3B, according to the chemical reaction equation (1) or (2).

However, the unexposed portions in the resist film 30 is removed relatively fast before the exposed portion 301 is removed, because of the chemical activity difference provided by the electron beam exposure. Thus, the portion 301 is left on the thin metal film 31 as the desired pattern of the resist film 30 as shown in FIG.3C. The resist pattern is used as the mask in the subsequent etching process of the film 31.

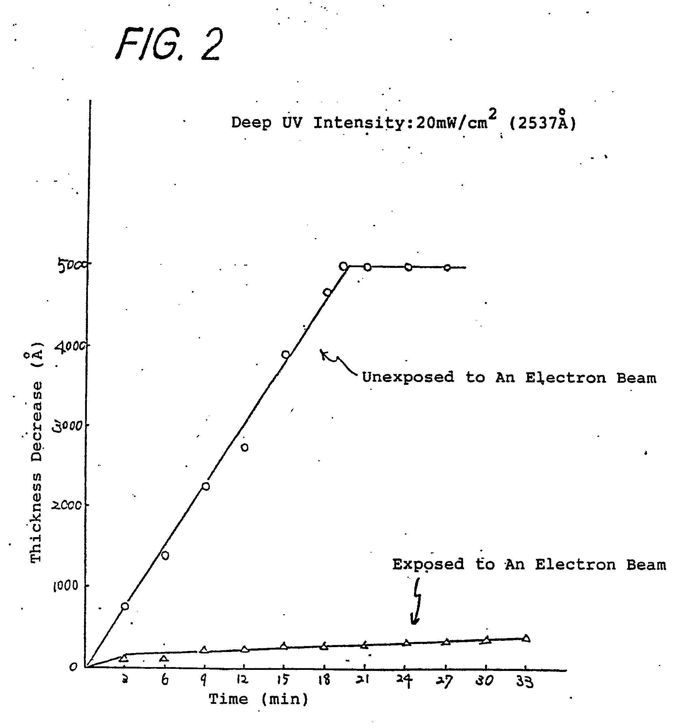

An experimental result of the dry development of a CMS resist film, which is carried out by using the apparatus as shown in FIG.1, is presented in FIG.2 showing the relation between the decrease in thickness and the time of exposure to the Deep UV of a CMS resist film having respective portions exposed and unexposed to an electron beam. FIG.2 reveals differential removal rates of about 300Å/min and 12Å/min for the respective portions unexposed and exposed to an electron beam. This means that the dry development of the CMS resist film of 5000Å can be achieved within 16 to 17 minutes and the loss in the thickness of the resist film at the exposed portion is as small as about 200Å which corresponds to 4% of the initial thickness, 5000Å. In the above, the substrate is left at room temperature, but if the substrate is raised to 100°C, the film removal rates become about 1.5 times larger.

Referring again FIG.1, the substrate 7 on the supporting table 8 is moved to and fro in the transferring directions in the work room 4 by means of the conveyer 9, and thus, uniform development can be attained.

A resist film formed from poly-glycidyl methacrylate (GMA) known as an electron beam resist of negative type can also be developed by using the dry method as described above. The contrast ratio of wet developed GMA resist films is generally low compared with that of CMS. The experimental result indicates that the low contrast characteristic of GMA is also maintained in the dry development of the present invention, however, the developed GMA resist film still remains in a practically usable grade.

It is obvious that the dry development of the present invention as described above can be applied to the films formed from a certain kind of positive-type electron-beam-sensitive resists including EBR-9 (marketed from Toray), because the differential oxidation reaction rates under the Deep UV irradiation can also be expected in the positive type resist film.

## Claims

1. A dry development method for a resist film, comprising steps of:

    forming a resist film on a substrate, said resist being sensitive to an electron beam;

    selectively exposing said resist film to said electron beam so that a latent image of a desired pattern is formed therein; and

    irradiating a deep ultra-violet ray to said resist film in an oxidizing gas of substantially atmospheric pressure, said resist film having been subjected to said selective exposure to said electron beam, whereby said resist film is selectively removed to form said desired pattern therein corresponding to said latent image.

2. A dry development method as set forth in claim 1, wherein said resist is a negative type.

3. A dry development method as set forth in claim 2, wherein said resist is composed of a chloro-methyl polystyrene.

4. A dry development method as set forth in claim 1, 2 or 3 wherein said deep ultra-violet ray having a spectral component of 253,7 nm (2537Å) or a shorter wave-length.

5. A dry development method as set forth in claim 4, wherein said deep ultra-violet ray having a spectral component at 184,9 nm (1849Å).

6. A dry development method as set forth in any of claims 1 to 5, wherein said oxidizing gas containing oxygen.

7. A dry development method as set forth in any of claims 1 to 6, wherein said oxidizing gas is atmospheric air.

8. A dry development method as set forth in any of claims 1 to 7, wherein said resist film is formed to have a thickness larger than 100,0 nm (1000Å).

## Revendications

1. Procédé de développement à sec d'une pellicule d'agent sensible de type réserve, comprenant les opérations suivantes :

    former une pellicule d'agent sensible sur un substrat, ledit agent étant sensible à un faisceau électronique ;

exposer sélectivement ladite pellicule d'agent sensible audit faisceau électronique de façon qu'une image latente d'un motif voulu y soit formée ; et

irradier ladite pellicule d'agent sensible à l'aide d'un rayonnement ultraviolet lointain dans un gaz oxydant se trouvant sensiblement à la pression atmosphérique, ladite pellicule d'agent sensible ayant été soumise à ladite exposition sélective audit faisceau électronique, si bien que ladite pellicule d'agent sensible est sélectivement retirée de manière à former ledit motif voulu correspondant à ladite image latente.

2. Procédé de développement à sec selon la revendication 1, où ledit agent sensible est d'un type négatif.

3. Procédé de développement à sec selon la revendication 2, où ledit agent sensible est composé d'un polystyrène chlorométhylé.

4. Procédé de développement à sec selon la revendication 1, 2 ou 3, où ledit rayonnement ultraviolet lointain possède une composante spectrale de 253,7 nm (2 537 Å) ou d'une longeur d'onde plus courte.

5. Un procédé de développement à sec selon la revendication 4, où ledit rayonnement ultraviolet lointain possède une composant spectrale de 184,9 nm (1 849 Å).

6. Procédé de développement à sec selon l'une quelconque des revendications 1 à 5, où ledit gaz oxydant contient de l'oxygène.

7. Procédé de développement à sec selon l'une quelconque des revendications 1 à 6, où ledit gaz oxydant est l'air atmosphérique.

8. Procédé de développement à sec selon l'une quelconque des revendications 1 à 7, où on forme ladite pellicule d'agent sensible de façon qu'elle ait une épaisseur supérieure à 100,0 nm (1 000 Å).

**Patentansprüche**

1. Trockenentwicklungsverfahren für einen Resistfilm, mit den Schritten:

Bilden eines Resistfilms auf einem Substrat, welches Resist gegenüber einem Elektronenstrahl empfindlich ist;

selektives Belichten des genannten Resistfilms mit dem genannten Elektronenstrahl, so daß ein latentes Bild eines gewünschten Musters darin gebildet wird; und

Einstrahlen eines tief ultravioletten Strahls auf den Resistfilm in einem oxidierenden Gas von im wesentlichen atmosphärischem Druck, welcher Resistfilm der genannten selektiven Belichtung durch den genannten Elektronenstrahl unterworfen worden ist, wodurch der genannte Resistfilm selektiv entfernt wird, um das gewünschte Muster darin zu bilden, welches dem genannten latenten Bild entspricht.

2. Trockenentwicklungsverfahren nach Anspruch 1, bei dem das Resist ein negativer Typ ist.

3. Trockenentwicklungsverfahren nach Anspruch 2, bei dem das Resist aus Chlormethylpolystyrol besteht.

4. Trockenentwicklungsverfahren nach Anspruch 1, 2 oder 3, bei dem der genannten tiefe ultraviolette Strahl eine spektrale Komponente von 253,7 nm (2537 Å) oder eine kürzere Wellenlänge hat.

5. Trockenentwicklungsverfahren nach Anspruch 4, bei dem der genannte tief ultraviolette Strahl eine spektrale Komponente bei 184,9 nm (1849 Å) hat.

6. Trockenentwicklungsverfahren nach einem der Ansprüche 1 bis 5, bei dem das genannte oxidierende Gas Sauerstoff enthält.

7. Trockenentwicklungsverfahren nach einem der Ansprüche 1 bis 6, bei dem das genannte oxidierende Gas atmosphärische Luft ist.

8. Trockenentwicklungsverfahren nach einem der Ansprüche 1 bis 7, bei dem der genannte Resistfilm so gebildet ist, daß er eine Dicke größer als 100,0 nm (1000 Å) hat.

# FIG. 1

Deep UV

NITROGEN GAS

FIG. 2

Deep UV Intensity:20mW/cm$^2$ (2537Å)

Unexposed to An Electron Beam

Exposed to An Electron Beam

Thickness Decrease (Å)

Time (min)

## FIG. 3 A

EB

301

30

31

32

## FIG. 3 B

Deep UV (1849$\overset{\circ}{A}$)

Deep UV (2537$\overset{\circ}{A}$)

$O^2$

$O^3$

$O^3$ $CO$, $H_2O$, $CO_2$

$O^*$ $CO$, $H_2O$, $CO_2$

301

30

31

32

## FIG. 3 C

301

31

32